# FASCICULE DE BREVET EUROPEEN

(11) **EP 3 227 475 B1**
(45) Date de publication et mention de la délivrance du brevet: **24.07.2019**
(21) Numéro de dépôt: 15802172.5
(22) Date de dépôt: 02.12.2015
(51) Int. Cl.: C30B 11/00, C30B 29/06, C30B 35/00

(54) **CREUSET RÉUTILISABLE POUR LA FABRICATION DE MATÉRIAU CRISTALLIN**
WIEDERVERWENDBARER TIEGEL ZUR HERSTELLUNG VON KRISTALLINEM MATERIAL
REUSIBLE CRUCIBLE FOR THE MANUFACTURE OF CRYSTALLINE MATERIAL

(30) Priorité: 02.12.2014 FR 1461768
(43) Date de publication de la demande: 11.10.2017
(73) Titulaire: Commissariat à l'Énergie Atomique et aux Énergies Alternatives, 75015 Paris (FR)
(72) Inventeur: TESTARD, Johann, 74290 Veyrier du Lac (FR); CAMEL, Denis, 73000 Chambéry (FR); RAYMOND, Olivier, 92231 Gennevilliers (FR); THUMMEN, Frédéric, 92231 Gennevilliers (FR)
(74) Mandataire: Talbot, Alexandre
(86) Numéro de dépôt international: PCT/EP2015/078424
(87) Numéro de publication internationale: WO 2016/087549

(56) Documents cités:
- JP-A- S62 108 515
- US-A- 4 941 647
- US-A1- 2006 219 162
- US-B1- 6 334 898

## Description

### Domaine technique de l'invention

L'invention concerne un creuset pour la fabrication de matériau cristallin tel que le silicium, par solidification et avantageusement par cristallisation dirigée, celui-ci étant muni d'un fond et de parois latérales.

### État de la technique

Le silicium utilisé dans l'industrie photovoltaïque est majoritairement du silicium cristallisé de structure multi-cristalline, c'est-à-dire des grains monocristallins sans orientation fixe les uns par rapport aux autres et entourés par des joints de grains. La croissance de ce type de matériau est réalisée à l'intérieur d'un creuset dans un four de cristallisation de type Bridgman.

Pour réduire les coûts de fabrication du silicium cristallin de qualité photovoltaïque, il est intéressant d'améliorer le rendement de purification du silicium métallurgique et également de réduire la quantité de matière nécessaire à la fabrication d'une cellule solaire.

De manière classique, le creuset est réalisé en silice et est recouvert d'un revêtement anti-adhérent. Les creusets en silice ne sont pas particulièrement avantageux car ils présentent une conductivité thermique faible ce qui limite l'agilité thermique du dispositif de cristallisation.

Afin de corriger ce problème, il est préférable de remplacer le creuset en silice par un creuset constitué de matériaux réfractaires permettant sa réutilisation
A titre d'exemple, les documents WO 2012/149151, US 6 334 898 et US 2006/0219162 décrivent des creusets réutilisables en graphite. Dans les deux cas, un revêtement de surface spécifique est utilisé pour réduire les interactions entre le matériau fondu et le creuset. Cette diminution des interactions entre la charge à cristalliser et le creuset doit permettre d'améliorer la durée de vie des creusets.

Cependant, dans tous les cas, les revêtements de surface proposés ne sont pas étanches à l'air : ils présentent ainsi une perméabilité résiduelle à l'air, ce qui présente notamment deux inconvénients majeurs, conduisant à une réduction de la durée de vie et de la sûreté de ces creusets dans leur utilisation au contact du silicium :
- La perméabilité à l'air favorise la désoxydation du revêtement, à la fois par le silicium et par le carbone sous-jacent. Les espèces SiO et O₂ issues de la réduction de la silice pouvant s'évacuer par les pores du revêtement et du creuset lui-même, et ainsi réagir avec le carbone qui le constitue. Ceci a pour effet d'accroitre la vitesse d'infiltration du revêtement par le silicium, celle-ci étant contrôlée par la cinétique de désoxydation du revêtement.
- Dans le cas où le silicium s'infiltre à travers le revêtement jusqu'au contact du creuset, même très localement, l'infiltration se poursuit au sein du creuset lui-même qui est lui-même perméable. Si le matériau présente des pores de tailles élevées (typiquement supérieures à 10 *µ*m dans le cas des composites, cette infiltration peut se poursuivre à travers toute l'épaisseur du creuset. De plus, dans le cas de graphite extrudé, le matériau éclate sous l'effet du gonflement des grains graphitiques lors de leur transformation en carbure de silicium.

Pour remédier à ces inconvénients, il a été proposé de former une couche étanche à l'air en surface d'un creuset en graphite dans la demande de brevet WO-A-201026344. Celle-ci, en carbure de silicium peut être obtenue par différentes méthodes, notamment par dépôt chimique en phase vapeur (CVD), ou par réaction du silicium liquide avec le graphite.

Cette solution, bien qu'adaptée aux creusets de fusion pour lesquels le liquide est ensuite versé dans une lingotière pour y être solidifié, n'est pas utilisable en tant que telle dans des creusets destinés à la fusion et à la recristallisation du silicium. En effet, le matériau de creuset permettant l'utilisation de cette solution a un coefficient de dilatation thermique plus élevé que celui du silicium. La différence de contraction des matériaux au cours du refroidissement qui suivrait la cristallisation du silicium provoquerait des contraintes entraînant la rupture du creuset et du silicium.

### Objet de l'invention

L'objet de l'invention a pour but de fournir un dispositif formant creuset, notamment un creuset pour la solidification dirigée réutilisable et présentant une durée de vie et une sûreté améliorés par rapport aux creusets actuels tout en préservant la qualité structurale et/ou chimique du matériau cristallisé, c'est-à-dire en évitant d'introduire des contraintes et/ou des fissures dans le matériau et/ou de le polluer.

On tend à atteindre cet objectif au moyen d'un creuset pour la fabrication d'un matériau cristallin par solidification, et notamment par cristallisation dirigée, comme décrit dans la revendication 1.

Ceci est rendu possible par la présence d'un système de serrage configuré pour autoriser l'écartement des deux parois latérales adjacentes si une contrainte seuil est appliquée sur les moyens de serrage.

Jusqu'à présent, il n'était en effet pas envisagé dans les creusets de cristallisation proposés dans l'art antérieur de réaliser les creusets en un matériau réfractaire avec un coefficient de dilatation thermique supérieur à celui du silicium car, dans ce cas, le matériau cristallin est enserré par le creuset au cours de son refroidissement à l'état solide, ce qui conduit à une accumulation de contraintes à la fois dans le silicium et dans le creuset, et aboutit à l'impossibilité de démouler le lingot, ou à la rupture du creuset et éventuellement du silicium.

Le fait de proposer dans le cadre de l'invention, un système de serrage configuré pour autoriser l'écartement des deux parois latérales adjacentes si une contrainte seuil est appliquée sur les moyens de serrage rend possible l'utilisation d'un tel matériau. Par ailleurs, dans le cas où le matériau réfractaire est du graphite ou du carbure de silicium massif, il rend également possible l'emploi d'une couche imperméable à l'air.

Dans ce cas, le matériau graphite utilisé pour former au moins une partie des parois du creuset est de manière avantageuse choisi pour présenter un coefficient de dilatation thermique avantageusement de l'ordre de celui du matériau constituant la couche imperméable à l'air. Avec le silicium comme matériau cristallin et du SiC pour la couche imperméable à l'air, cela revient au fait qu'il soit supérieur à celui du silicium.

L'invention a également pour objet de fournir un procédé de fabrication du creuset.

On tend à atteindre cet objectif au moyen d'un procédé qui comporte :
- Fournir au moins deux parois latérales formées au moins partiellement par un matériau réfractaire ayant un coefficient de dilatation thermique moyen, dans une gamme de température comprise entre la température ambiante et la température de fusion du matériau cristallin, supérieur ou égaleau coefficient de dilatation thermique dudit matériau cristallin dans ladite gamme de température,
- Assembler les parois latérales, les au moins deux parois latérales adjacentes étant connectées au moyen du système de serrage, le système de serrage étant configuré pour autoriser l'écartement des deux parois latérales adjacentes si une contrainte seuil est appliquée sur les moyens de serrage,
- Assembler le fond aux parois latérales.

L'invention a également pour objet de fournir un procédé de cristallisation au moyen dudit creuset d'un lingot de silicium, comme défini dans la revendication 13.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1, représente une vue schématique, en coupe transversale, d'un creuset comportant un germe, selon l'invention;
- les figures 2 et 3 représentent de manière schématique, en vue de dessus deux modes de réalisation d'un creuset avec un arrangement particulier des parois latérales ;
- les figures 4 à 6 représentent de manière schématique, en vue de dessus les déplacements des parois latérales dans un creuset ;
- la figure 7 représente, de manière schématique, en vue de coupe, un système de serrage formé par une vis, un écrou et un élément compressible ;
- la figure 8 représente, de manière schématique, en vue de coupe, un creuset rempli par un lingot qui appuie sur les parois latérales.

### Description de modes de réalisation préférentiels de l'invention

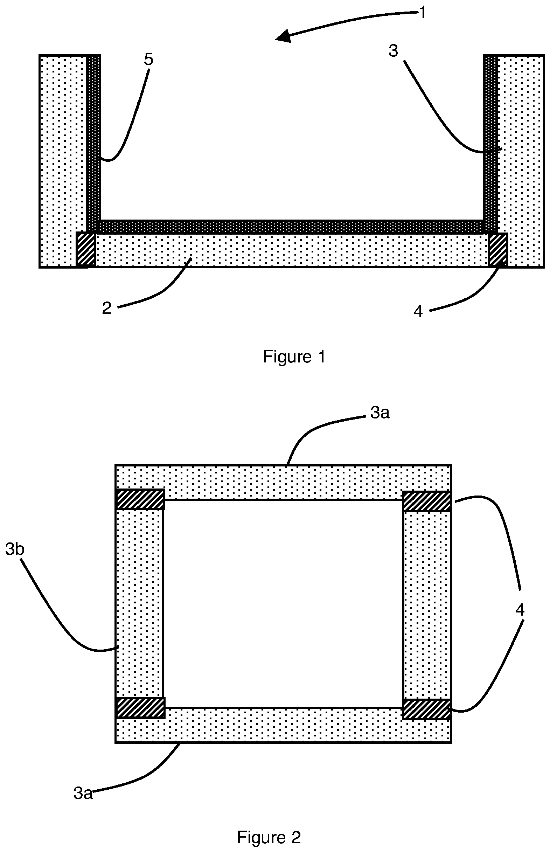

Comme illustré à la figure 1, le dispositif formant creuset 1, par la suite appelé creuset, comporte un fond 2 et des parois latérales 3. La forme du creuset 1 est quelconque. A titre d'exemple, la section, c'est-à-dire la forme dessinée par le fond 2 du creuset peut être carrée, rectangulaire ou polygonale ou circulaire. Avantageusement, les parois latérales 3 sont formées par des plaques qui sont avantageusement planes.

Dans le cas d'un creuset, par exemple, de section carrée ou rectangulaire, le creuset 1 comporte plusieurs parois latérales 3 reliées deux à deux de manière à délimiter, avec le fond 2, l'espace intérieur du creuset destiné à recevoir le matériau cristallin lors de sa fusion et de sa solidification par cristallisation dirigée. Dans le cas d'un creuset à section cylindrique, par exemple cylindrique de révolution, le creuset 1 comporte au moins deux parois latérales 3 qui s'étendent suivant la périphérie du fond de manière à délimiter, avec le fond 2, l'espace intérieur du creuset. Les parois latérales 3 sont perpendiculaires au fond 2 du creuset 1 ou sensiblement perpendiculaires au fond 2.

Le fond 2 et les parois latérales 3 du creuset 1 forment une surface interne étanche au matériau fondu.

Le creuset 1 est réalisé dans un matériau réfractaire, résistant aux fortes températures subies lors des phases de fusion et de solidification du matériau à fondre puis à solidifier. Le matériau réfractaire est, en particulier, choisi parmi le graphite, le carbure de silicium et le nitrure de bore.

A titre d'exemple, un premier gradient thermique est généré dans le creuset 1 de manière à faire fondre le matériau à solidifier. Un second gradient thermique est généré dans le creuset 1 de manière à solidifier le matériau à l'état fondu.

De manière avantageuse, afin de présenter une bonne agilité thermique, le creuset peut être au moins partiellement formé en graphite. Le creuset comporte ainsi un fond 2 et des parois latérales 3 formées au moins partiellement en graphite. De manière encore avantageuse, le fond et les parois latérales 3 sont en graphite.

Le creuset 1 comporte également un système de serrage 4 configuré pour maintenir ensemble aux moins deux parois latérales adjacentes du creuset 1.

Le système de serrage 4 peut également être utilisé pour solidariser les parois latérales avec le fond du creuset 1. Dans un mode de réalisation particulier, le fond n'est pas solidarisé aux parois latérales. Le fond supporte les parois latérales.

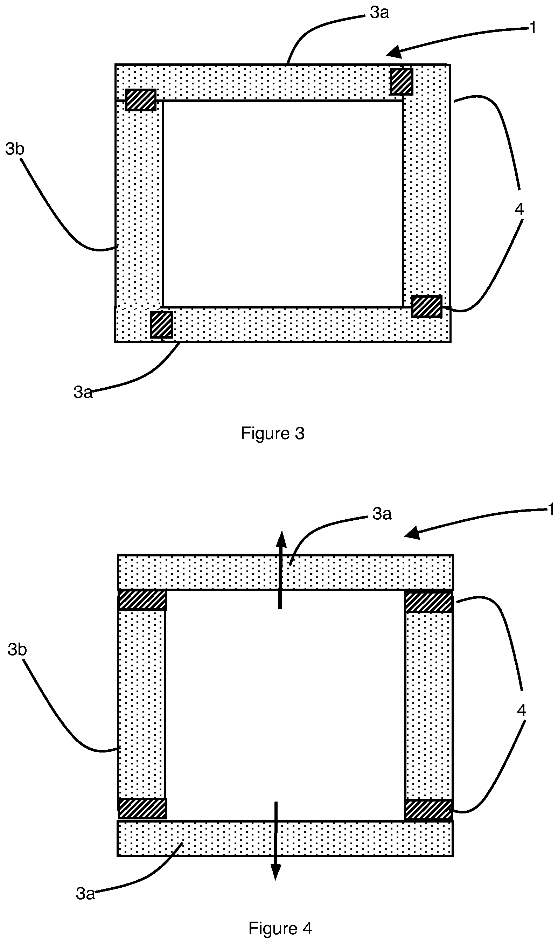

Comme illustré aux figures 2 et 3, le système de serrage 4 est configuré pour maintenir en contact les parois latérales 3 lors de la phase de fusion de la charge à cristalliser. Le système de serrage 4 est également configuré pour maintenir en contact les parois latérales 3 lors de la phase de cristallisation ou durant une partie de la phase de cristallisation.

Le système de serrage 4 est configuré pour autoriser l'écartement des deux parois latérales 3 adjacentes si une contrainte seuil est appliquée sur les moyens de serrage. Cette contrainte seuil peut apparaitre lors de la phase de solidification quand le matériau formant le creuset présente un coefficient de dilatation thermique moyen supérieur au coefficient de dilatation thermique moyen dudit matériau cristallin en phase de solidification. Il est particulièrement avantageux de comparer les coefficients de dilatation thermique moyens sur la gamme de température allant de la température ambiante à la température de fusion du matériau cristallin.

La pression exercée par le matériau fondu est faible. La pression exercée par le matériau fondu est liée à la hauteur de matériau à cristalliser dans le creuset. Au début de la cristallisation, la différence de coefficient de dilatation ne génère pas une contrainte importante car les dimensions de la phase solide sont définies par les dimensions du creuset. Cette contrainte augmente au fur et à mesure du refroidissement.

Comme le creuset n'est pas monolithique, même si la mise en contact des parois latérales 3 n'est pas parfaite, l'étanchéité au matériau fondu peut être obtenue. En particulier, l'homme du métier fera attention à ne pas mouiller deux faces en regard par un liquide. Dans le cas où de fines fentes sont présentes entre deux parois adjacentes, si la largeur de la fente est assez faible, la résistance capillaire s'oppose à la pénétration du matériau fondu dans la fente. De cette manière, la résistance capillaire s'oppose à la sortie du matériau fondu hors du creuset 1.

La valeur du jeu acceptable entre deux plaques latérales 3 adjacentes peut être déterminée au moyen de l'angle de mouillage entre le matériau fondu et le matériau formant le revêtement de surface interne du creuset 1. La valeur du jeu acceptable entre deux plaques latérales 3 consécutives est également déterminée au moyen de la pression hydrostatique appliquée par le matériau fondu et qui correspond à la hauteur de matériau fondu dans le creuset 1.

Il est particulièrement avantageux de former un revêtement 5 ayant des propriétés anti-mouillantes aux zones de contact entre deux parois latérales 3 adjacentes, afin de limiter les risques de fuite du matériau fondu. Le matériau anti-mouillant va augmenter l'angle de mouillage entre le matériau fondu et le revêtement 5 ce qui va réduire les risques de fuite.

A titre d'exemple, pour une hauteur de silicium liquide égale à 30 cm dans un creuset 1 muni d'un revêtement à base de Si₃N₄ oxydé, une fente ayant une largeur inférieure ou égale à 100µm peut être acceptée.

Ce qui vient d'être expliqué pour deux parois latérales 3 adjacentes peut également être appliqué pour la zone de contact entre une paroi latérale 3 et le fond 2.

Le revêtement 5 peut également présenter des propriétés d'anti-adhérence. Le revêtement 5 est alors préférentiellement déposé sur toutes les faces du creuset amenées à être en contact avec le matériau à cristalliser. Cette spécificité permet d'éviter un collage du matériau solidifié avec le creuset.

La couche anti-adhérente est avantageusement une couche poreuse qui n'est pas ou peu infiltrée par le matériau cristallin par exemple par le silicium (notamment à l'état fondu) de sorte que le silicium solidifié présente une adhésion faible avec la couche anti-adhérente.

A titre d'exemple, une couche anti-adhérente constituée de poudre de nitrure oxydée ayant une épaisseur comprise entre 50µm et 1000µm a donné de bons résultats expérimentaux.

Selon les modes de réalisation, le revêtement 5 peut être formé par une couche ayant des propriétés d'anti-adhérence et/ou par une couche ayant des propriétés anti-mouillantes. Un empilement de ces couches peut être réalisé. Il est également possible de déposer une couche qui comporte les deux propriétés.

Dans un mode de réalisation particulier, les différents matériaux permettant de former un revêtement 5 avec des propriétés anti-mouillantes et d'anti-adhérence sont déposés simultanément sur les différents éléments formant le creuset avant d'assembler le creuset.

Il est également possible de déposer une couche supplémentaire de revêtement localement au niveau des joints entre les éléments, à l'intérieur du creuset, après son assemblage.

La qualité d'anti-adhérence d'une couche anti-adhérente peut être analysée par le dépôt d'une goutte de silicium sur la couche anti-adhérente et avec l'étude de la variation de son volume dans le temps. Plus la variation de volume de la goutte de silicium est importante et plus le silicium s'est introduit dans la couche anti-adhérente. Il en ressort que plus la variation de volume est importante et moins bonnes sont les qualités d'anti-adhérence de la couche étudiée. De manière classique, la couche anti-adhérente étudiée est déposée sur une couche du matériau formant le creuset 1 afin de se rapprocher au maximum des conditions réelles d'utilisation.

Dans un mode particulier de réalisation illustré à la figure 1, le fond 2 et/ou les parois latérales 3 du creuset 1 sont partiellement ou complètement recouverts du revêtement 5.

De plus, notamment dans le cas d'un creuset en graphite, les parois internes du creuset sont en général préalablement recouvertes d'une couche imperméable 5a aux gaz et préférentiellement aux gaz présents dans le creuset 1 durant la phase de fusion/solidification, de préférence imperméable à l'air. La couche imperméable recouvre alors au moins une partie interne du creuset 1.

L'utilisation d'une couche imperméable aux gaz permet en effet de réduire la désoxydation du revêtement 5, notamment au moyen du silicium et/ou au moyen du carbone qui peut être présent dans la charge à cristalliser. Il est particulièrement avantageux de disposer cette couche imperméable entre la paroi du creuset 1 et la couche anti-adhérente. Dans un mode de réalisation préférentiel, la couche imperméable est imperméable à l'air et elle est à base de carbure de silicium.

Les revêtements à base de nitrure de silicium et/ou d'oxyde de silicium ne sont pas performants en ce qui concerne l'imperméabilité à l'air. Afin d'augmenter la durée de vie du creuset 1, il est donc particulièrement avantageux de disposer entre la paroi du creuset 1 et la couche anti-adhérente 5 une couche imperméable 5a dans un matériau plus adapté.

Dans le cas d'une charge à base de silicium à l'intérieur d'un creuset en graphite, les inventeurs ont découvert que le caractère étanche de la couche imperméable 5a empêche l'évacuation des espèces SiO et O₂ qui proviennent de la réduction de la silice. De cette manière, les espèces SiO et O₂ ne peuvent plus s'évacuer par les pores du creuset 1 et réagir avec le graphite constituant le creuset 1, ce qui limite la désoxydation de la couche anti-adhérente, qui conduirait à la perte de ses caractéristiques d'anti-adhérence. L'utilisation d'une couche imperméable aux gaz réduit ainsi le risque de contact entre le matériau fondu et le creuset, et de collage du matériau cristallisé sur le creuset 1, pour une meilleure tenue du creuset 1 dans le temps.

Un exemple de mise en oeuvre d'un revêtement à base de SiC est décrit dans le document WO 2010/026344.

En l'absence de couche imperméable, une fois que le matériau liquide (ici du silicium) s'est infiltré dans le creuset 1, par exemple à travers la couche anti-adhérente, il est possible de former du carbure de silicium. Cette transformation du creuset à base de graphite peut aboutir à un éclatement du matériau lors de la phase de refroidissement.

Il est particulièrement avantageux de former une couche imperméable en carbure de silicium (SiC) sur un creuset en graphite, car la couche de revêtement imperméable présente une très bonne adhérence et une bonne couverture avec le matériau formant le creuset 1. Pour un creuset en graphite, la couche en SiC peut être formée par différentes techniques, par exemple au moyen d'un dépôt chimique en phase vapeur ou par réaction du silicium liquide avec le graphite.

La couche imperméable est avantageusement formée par une couche superficielle de SiC sur le creuset 1 avant de former les couches anti-adhérentes/anti-mouillantes. La couche de SiC présente l'avantage d'être un matériau imperméable aux gaz et notamment à l'air. Un revêtement à base de SiC est particulièrement intéressant car il montre une tenue importante jusqu'à une température sensiblement égale à 1550°C.

L'utilisation d'une couche en SiC donne de meilleurs résultats que ce qui est décrit dans le document US 2006/0219162. Le document US 2006/0219162 divulgue un creuset en graphite qui est formé par plusieurs éléments qui sont assemblés ensemble mécaniquement. Le revêtement intérieur du creuset est réalisé au moyen d'une tri-couche Si₃N₄/SiO₂/Si₃N₄ recuite sous air à 600°C ou sous gaz neutre à 1500°C.

Le document WO 2012/149151 divulgue un creuset monobloc en graphite muni d'un revêtement intérieur à base d'un mélange de poudre de SiO₂ et Si₃N₄.

Pour un creuset en graphite, une manière de savoir si une couche peut être considérée comme perméable ou imperméable à l'air est de lui appliquer traitement thermique de 4 heures à 1100°C sous air.

La couche est considérée imperméable si la perte de poids est inférieure à 10⁻³g/cm² de surface recouverte. La couche étudiée recouvre un substrat en graphite.

Lors d'un tel recuit, si le matériau recouvrant les parois du creuset n'est pas imperméable, une partie du creuset et notamment le graphite est brulé. Il y a alors consommation du creuset ce qui se traduit par une diminution de la masse du creuset.

En revanche, si une couche imperméable en SiC est utilisée, on observe une augmentation de la masse à cause de l'oxydation superficielle de la couche de SiC.

Ainsi, afin d'accroitre la durée de vie du creuset, il est particulièrement intéressant de déposer un revêtement comportant une couche de SiC sur un matériau ayant un coefficient de dilatation thermique égal ou sensiblement égal à celui du carbure de silicium. Il est particulièrement avantageux de comparer les coefficients de dilatation thermique moyens, c'est-à-dire la valeur moyenne des coefficients de dilatation thermique sur une gamme de température prédéfinie. D'une manière plus générale, il est intéressant d'accroître la durée de vie de la couche imperméable en ajustant le coefficient de dilatation thermique du revêtement imperméable à celui du matériau formant le creuset recouvert par cette couche. La gamme de température est avantageusement celle définie précédemment. A titre d'exemple, il est avantageux de comparer les coefficients de dilatation thermique moyens dans une gamme de température comprise entre la température ambiante et la température de fusion du matériau à solidifier. Cependant, il est également possible de prendre une autre gamme de température. Par température ambiante, on entend une température égale ou sensiblement égale à 20°C.

Ainsi, de préférence, au moins une partie du creuset est recouverte par la couche imperméable. Avantageusement, au moins les parois latérales sont recouvertes par la couche imperméable.

La couche imperméable recouvre avantageusement le fond 2 et les parois latérales 3 internes du creuset, c'est-à-dire toutes faces qui seront en contact avec le matériau à cristalliser. L'épaisseur de la couche imperméable est avantageusement comprise entre 50 µm et 200 µm pour éviter l'infiltration du matériau fondu dans le creuset 1 et/ou le passage des gaz.

De cette manière, en plus de ses propriétés anti-adhérentes déjà discutées, le revêtement de surface 5 permet de protéger le creuset 1 contre une infiltration du matériau fondu ce qui permet d'assurer la tenue dans le temps du creuset.

Afin de se rapprocher du coefficient de dilatation thermique du revêtement en SiC ou base de SiC, il est particulièrement intéressant de former un creuset en graphite qui présente un coefficient de dilatation supérieur à celui du silicium. Cette configuration permet de limiter les contraintes entre le matériau du creuset et le matériau de la couche imperméable à l'air.

A titre d'exemple, un graphite ayant un coefficient de dilatation thermique supérieur à celui du silicium et avantageusement sensiblement égal à celui du carbure de silicium peut être formé par extrusion pour obtenir du graphite extrudé ou par vibrotassage pour obtenir du graphite vibrotassé. Un graphite isostatique permet également d'avoir un coefficient de dilatation thermique supérieur à celui du silicium et avantageusement sensiblement égal à celui du carbure de silicium. Le graphite isostatique peut être formé par tout procédé adapté.

De manière préférentielle, la couche à base de SiC est réalisée sur un creuset formé dans un matériau qui présente une porosité fine pour obtenir une bonne accroche sur le creuset 1. A titre d'exemple, une taille moyenne de pores de quelques micromètres a donné de bons résultats, typiquement pour une taille moyenne de pores comprise entre 1 et 10µm.

La couche superficielle de SiC présente une tenue accrue sur les éléments en graphite isostatique ce qui lui confère une durée de vie importante et permet plusieurs utilisations du creuset. Ainsi, le creuset est protégé et il dure plus longtemps que les creusets de l'art antérieur.

Dans une variante de réalisation, la couche de SiC peut être associée à une couche en nitrure de silicium qui est avantageusement oxydée sur la surface de contact avec la future charge de manière à former un revêtement anti-mouillant.

Dans un mode de réalisation particulier, il est intéressant de former au moins une paroi latérale du creuset dans un matériau ayant un coefficient de dilatation thermique supérieur à celui du silicium et avantageusement sensiblement égal à celui de la couche en carbure de silicium. Avantageusement, toutes les parois latérales sont formées dans ce matériau. De manière préférentielle, les parois latérales du creuset sont constituées par le matériau réfractaire.

Dans un mode de réalisation préférentiel, le fond est également réalisé dans un matériau présentant un coefficient de dilatation thermique supérieur à celui du silicium et avantageusement sensiblement égal à celui de la couche en carbure de silicium pour limiter les contraintes mécaniques lors des cycles thermiques.

Ainsi, pour le cas d'une couche imperméable en carbure de silicium, le matériau du creuset, par exemple du graphite, a avantageusement un coefficient de dilatation moyen, dans la gamme 0°C et 1000°C, supérieur à 4x10⁻⁶/°C et inférieur à 8,5x10⁻⁶/°C et encore plus avantageusement entre 4,4 x10⁻⁶ et 5,4x10⁻⁶/°C. A titre d'exemple, il peut s'agir d'un graphite de nuance 2020 ou 2320 commercialisé par la société MERSEN.

Dans un mode de réalisation particulier, le creuset 1 est réalisé en graphite isostatique, préférentiellement en graphite isostatique à grains fins, comme la nuance 2320 commercialisée par la société MERSEN. Cette nuance est particulièrement adaptée au dépôt d'une couche étanche de SiC et notamment par un dépôt de type dépôt chimique en phase vapeur (CVD). De manière avantageuse, le graphite utilisé présente une masse volumique de l'ordre 1,82 g/cm³. Il présente également une porosité de l'ordre de 10% et une taille de grain égale à 13µm. Pour ce type de matériau, le coefficient de dilatation thermique moyen entre 0°C et 1000°C est de l'ordre de 4.8x10⁻⁶/°C.

Il est également possible d'utiliser la nuance 2020 de graphite commercialisée par la société MERSEN. Cette nuance est particulièrement adaptée au dépôt d'une couche étanche de SiC et notamment par infiltration réactive. De manière avantageuse, le graphite utilisé présente une masse volumique de l'ordre de 1,77 g/cm³. Il présente également une porosité de l'ordre 15% et une taille de grain égale à 15 m. Pour ce type de matériau, le coefficient de dilatation thermique moyen entre 0°C et 1000°C est égal à 4,2x10⁻⁶/°C. La taille moyenne des pores a été mesurée entre 1 et 3µm (mesure par porosimétrie mercure).

Le système de serrage 4 est configuré pour écarter au moins une paroi latérale 3 lorsque la contrainte exercée sur cette paroi est supérieure à une valeur seuil. Ainsi, tant que la pression exercée par le lingot sur la paroi latérale est inférieure à la valeur seuil, les deux parois latérales 3 sont en contact pour former un creuset étanche. Lorsque la valeur seuil est atteinte, la paroi latérale se déplace. La paroi qui se déplace n'est pas fixe par rapport au fond 2. La paroi latérale 3 est donc montée mobile, mais elle ne se déplace que si la contrainte appliquée est supérieure à la valeur seuil. Le creuset 1 n'est plus étanche, mais au moins le fond 2 du creuset 1 est recouvert par le matériau cristallisé.

L'utilisation d'un tel système de serrage 4 permet de contrôler la pression exercée sur les faces en contact pour assurer l'étanchéité lors de la phase de fusion. Le système de serrage 4 permet également de limiter la contrainte générée sur le lingot 9 en cours de cristallisation lorsque le coefficient de dilatation thermique du matériau solidifié est inférieur au coefficient de dilatation thermique du matériau formant au moins une partie du creuset 1.

Dans un mode de réalisation particulier, le système de serrage 4 est configuré de manière à ce que la contrainte de compression exercée par les parois latérales 3 du creuset 1 sur le lingot soit inférieure à 1 MPa ce qui est inférieur aux contraintes d'origine thermomécanique généralement engendrées dans les lingots par les gradients de température présents au cours du refroidissement. De manière particulièrement avantageuse, le système de serrage 4 est configuré de manière à ce que la contrainte de compression exercée par les parois latérales 3 du creuset sur le lingot soit inférieure à 0,2 MPa.

Au démarrage de la solidification, les dimensions du lingot sont imposées par les dimensions du creuset 1. Au fur et à mesure de la descente en température, les dimensions du creuset 1 diminuent et il en va de même pour la portion du matériau qui se solidifie. Cependant, la partie déjà solidifiée voit ses dimensions évoluer en fonction de son coefficient de dilatation ou en fonction des contraintes appliquées par le creuset 1. Si le creuset se contracte plus vite que le lingot, la descente en température se traduit par une augmentation des contraintes exercées entre le lingot 9 et le creuset 1. Le système de serrage 4 permet de définir une contrainte maximale qui ne sera pas dépassée car le creuset 1 va commencer à s'ouvrir.

Dans un autre mode de réalisation, la paroi latérale 3 est connectée aux deux autres parois latérales 3 au moyen d'un système de serrage 4 de manière que la contrainte soit réduite sur toute la paroi latérale qui est montée mobile et non sur une partie seulement de la paroi latérale. De cette manière, les risques de fragilisation du creuset sont réduits. Dans ce mode de réalisation, la contrainte peut être réduite dans une direction du creuset et du lingot matérialisée par la perpendiculaire à la paroi mobile du creuset, ce qui correspond sensiblement à l'axe de déplacement de la paroi latérale par rapport aux deux parois latérales adjacentes.

Dans une variante de réalisation illustrée à la figure 4, les deux parois latérales 3 opposées sont montées mobiles ce qui permet de réduire les contraintes dans l'axe de déplacement des parois latérales 3 en réduisant le déplacement du lingot sur le fond 2 du creuset ce qui permet de garantir la qualité cristallographique du lingot.

Dans un autre mode de réalisation, deux parois latérales 3 non opposées sont associées aux autres parois latérales 3 au moyen du système de serrage 4. Dans ce mode de réalisation, les contraintes appliquées peuvent être relâchées dans deux axes différents.

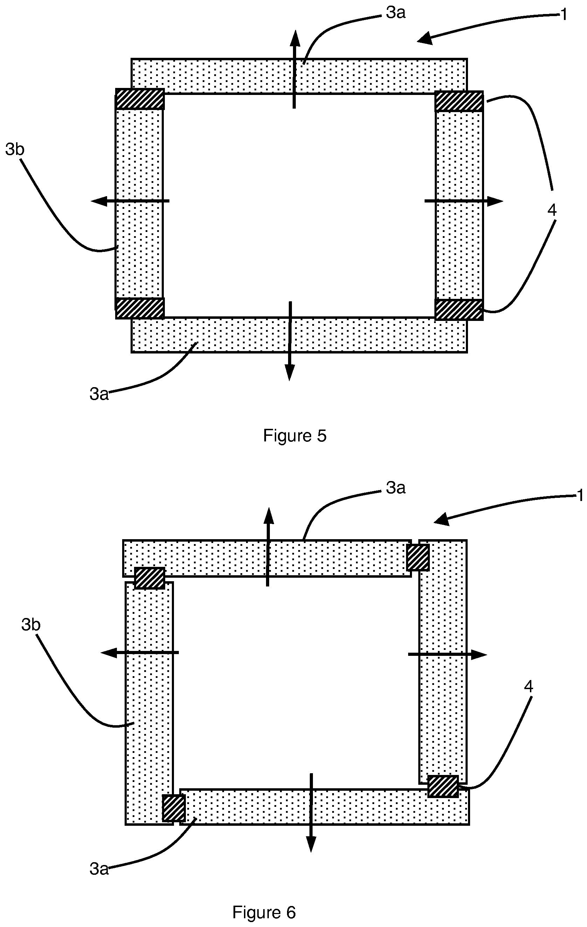

Dans un mode de réalisation particulièrement avantageux illustré aux figures 5 et 6, toutes les parois latérales 3 sont montées mobiles, ce qui permet de limiter au maximum les contraintes dans le lingot et de limiter le déplacement du lingot par rapport au fond 2 du creuset. Chaque paroi latérale 3 est avantageusement connectée à la paroi latérale 3 adjacente au moyen d'un système de serrage 4.

Le système de serrage 4 est formé avec des matériaux qui conservent leurs caractéristiques mécaniques dans toute la gamme de température utilisée par le creuset, c'est-à-dire depuis la température ambiante jusqu'à la température de fusion du matériau à cristalliser. A titre d'exemple, pour le silicium, le système de serrage 4 supporte des températures supérieures ou égales à 1410°C.

Dans un mode de réalisation qui peut être combiné aux modes de réalisation précédents, le déplacement procuré par le système de serrage 4 est continu et progressif au fur et à mesure du refroidissement de manière à tenir compte de la différence dimensionnelle qui existe entre le creuset 1 et le lingot.

De manière avantageuse, le système de serrage 4 comporte un élément déformable 6 qui va se déformer, de préférence se comprimer, pour supporter une partie des contraintes présentes dans le creuset. Il est possible d'utiliser un élément déformable élastiquement ou plastiquement. Il est préférable d'utiliser un élément déformable 6 élastiquement car il peut être réutilisé plusieurs fois alors que l'élément déformable plastiquement est plus difficile à réutiliser.

Dans un mode de réalisation particulièrement avantageux, l'élément déformable 6 est un élément formé par un matériau compressible réfractaire qui peut se déformer au cours de la phase de fabrication d'un lingot et/ou qui présente une forme autorisant sa compression lors de l'application de la contrainte seuil de traction, par exemple sous la forme d'un ressort. Parmi les matériaux compressibles réfractaires, on peut citer les matériaux réfractaires métalliques, céramiques, en carbone, par exemple un graphite souple, et les composites carbone-carbone.

De manière avantageuse, l'élément déformable en graphite souple a une compressibilité maximale comprise entre 42% et 52%. Dans un mode de réalisation particulier, à l'issue du serrage, l'élément déformable a un taux de compression compris en 10% et 30%, c'est-à-dire que la variation de volume par rapport à l'état non contraint est comprise entre 10% et 30%. La faible compression appliquée sur l'élément déformable à l'état initial permet d'assurer une bonne tenue mécanique du creuset et d'éviter des fuites lorsque la charge est à l'état fondu.

Dans la mesure où l'élément déformable présente une marge de compressibilité importante, lors de la phase de refroidissement, l'élément déformable peut encore se comprimer pour absorber les contraintes (ou déplacement) provenant de la différence de coefficient de dilatation thermique entre le matériau formant le creuset 1 et le matériau formant la charge à cristalliser.

L'élément déformable peut être une rondelle compressible, par exemple une feuille de graphite souple, qui peut facilement se comprimer. En variante, il est également possible de prévoir un ressort en carbone ou dans un autre matériau apte à résister au cycle thermique appliqué. Il est particulièrement avantageux d'utiliser une rondelle en graphite souple compressible car elle présente un risque faible de défaillance.

Dans une variante de réalisation, le système de serrage 4 comporte un ressort configuré pour écarter les parois latérales 3 et le ressort est maintenu comprimé au moyen d'un bloqueur. Il est encore possible de fixer directement les parois latérales 3 au moyen du bloqueur. De cette manière, au fur et à mesure que la température diminue, la contrainte augmente jusqu'à atteindre la valeur seuil qui génère la déformation du bloqueur autorisant un déplacement de la paroi latérale.

Dans une autre variante de réalisation, les parois latérales sont structurées de manière à s'imbriquer à force l'une dans l'autre, par exemple avec une structuration en forme de peigne.

Dans une variante de réalisation, le déplacement de la paroi latérale est réalisé en une seule fois dès que la contrainte seuil est atteinte, de manière instantanée. Comme précédemment, le système de serrage 4 peut comporter un ressort associé à un bloqueur. Lorsque la contrainte seuil est atteinte, le bloqueur cède ce qui libère la paroi latérale qui peut se déplacer. A titre d'exemple, il est possible d'utiliser une goupille en carbone qui travaille en flexion ou un cantilever simple ou double.

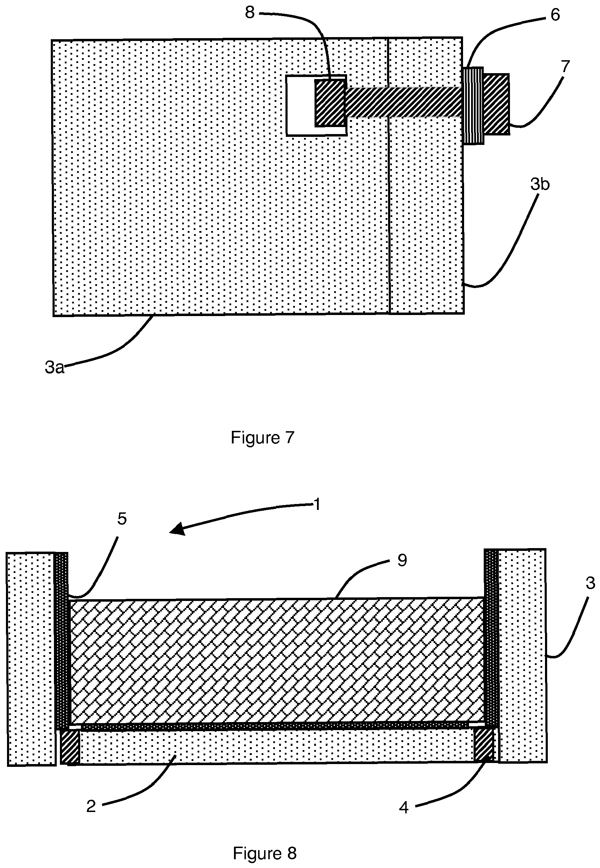

Le système de serrage 4 peut être réalisé par tout moyen adapté. Préférentiellement, le système de serrage 4 comporte des moyens de fixation en carbone, par exemple en carbone, en graphite ou en carbone composite. Les moyens de fixation peuvent être une vis et un écrou ou un autre système d'accouplement comportant un élément maie et un élément femelle ou une pièce unique qui solidarise deux parois latérales. La figure 7 illustre un mode de réalisation avec une rondelle compressible maintenue en compression au moyen d'une vis 7 qui s'enfonce dans deux parois latérales pour coopérer avec un écrou 8 logé dans un trou de fixation. Les positions de la tête de vis et de l'écrou peuvent être inversées. Il est également possible de placer le matériau compressible dans le trou de fixation. Dans un mode de réalisation particulier, le système de serrage 4 comporte une vis, un écrou et une rondelle 6 en graphite souple formant l'élément déformable, la rondelle étant configurée pour se comprimer lorsque la contrainte seuil de traction est appliquée entre la vis 7 et l'écrou 8.

Le système de serrage 4 peut également prévoir que la vis s'engage dans une des parois adjacentes qui comporte un taraudage intérieur. Inversement, une des parois peut comporter une portion filetée en saillie qui vient coopérer avec un écrou pour solidariser une autre paroi latérale.

Chaque plaque comporte deux faces principales opposées (une face interne et une face externe) et deux faces secondaires opposées. Dans un mode de réalisation illustré à la figure 2, la section du creuset est un quadrilatère et deux parois latérales 3a opposées sont séparées par les deux autres parois latérales 3b. Deux faces extérieures opposées du creuset sont formées par deux faces principales externes de deux premières plaques. Les deux autres faces extérieures sont formées par deux faces principales externes de deux deuxièmes plaques prolongées par les faces secondaires des deux premières plaques.

Dans cette configuration, chaque système de serrage 4 est avantageusement configuré pour autoriser un déplacement des plaques selon deux axes différents.

Dans une autre configuration illustrée à la figure 3, une face secondaire d'une première plaque vient s'appuyer sur une face principale interne d'une deuxième plaque adjacente. La face secondaire de cette deuxième plaque vient appuyer sur la face principale interne de la première plaque opposée. La face secondaire de cette première plaque opposée vient s'appuyer contre la face principale interne de la deuxième plaque opposée. La face secondaire de cette deuxième plaque opposée vient s'appuyer contre la face principale interne de la première plaque pour fermer le creuset.

Ce mode de réalisation particulier, est particulièrement avantageux car il permet le décalage des parois latérales 3 selon les deux axes en disposant les systèmes de serrage 4 de manière à traverser les deux faces principales d'une paroi pour s'engager dans la face secondaire de la paroi adjacente. Cette configuration peut être utilisée avec un système de serrage 4 qui ne travaille que dans un seul axe ou avec un système de serrage 4 qui autorise un déplacement dans deux axes différents.

Dans un mode de réalisation particulier, les parois latérales 3 s'appuient sur le fond 2 du creuset. Dans une autre configuration, les parois latérales 3 sont séparées par le fond 2 du creuset.

Dans un mode de réalisation particulier, le creuset est réalisé dans une nuance de graphite 2320 commercialisée par la société MERSEN. Cette nuance de graphite présente une différence de dilatation avec le silicium égale à 0,18% entre la température ambiante et la température de fusion du silicium. Ainsi, pour un creuset de type G1 ayant une dimension latérale égale à 200mm, le déplacement de chaque paroi latérale entre la position non contrainte et la position contrainte est égal à 180µm lors de la solidification du silicium. En d'autres termes, pour réduire les contraintes entre le creuset et le lingot, les deux parois latérales 3 opposées doivent se déplacer de 180µm pour tenir compte de la plus forte rétraction du creuset lors du refroidissement. Pour un creuset de type G5 ayant une dimension latérale égale à 800mm, le déplacement à prévoir est d'environ 0,7mm.

Pour ce type de creuset, l'élément déformable peut être une feuille ou un empilement de feuilles en graphite ayant par exemple une épaisseur égale à 2mm. Dans un mode de réalisation particulier, il est avantageux d'utiliser du graphite expansé comprimé pour réaliser l'élément déformable. A titre d'exemple, un graphite expansé comprimé de type Papyex® commercialisé par Mersen peut être utilisé.

Avantageusement, pour la formation d'un creuset ayant une section carrée ou rectangulaire, quatre plaques forment les parois latérales 3 et une cinquième plaque forme le fond 2 du creuset. Il peut être préférable d'utiliser une sixième plaque pour former le sommet du creuset, c'est-à-dire un couvercle. Dans un mode de réalisation particulier, le couvercle comporte un trou débouchant qui peut autoriser le passage d'une canne de soufflage. La canne de soufflage permet l'injection d'un gaz à la surface de la charge ou dans la charge.

A titre d'exemple, le fond 2 peut être formé par une plaque de section carrée ayant les dimensions suivantes : 240^{∗}240mm². L'épaisseur de la plaque est avantageusement égale à 20mm. Des dimensions similaires peuvent être utilisées pour former le couvercle du creuset. Le trou pour la canne de soufflage peut avoir un diamètre égal à 40mm.

Les quatre plaques formant les parois latérales 3 ont les dimensions suivantes 300^{∗}220mm². L'épaisseur des plaques est avantageusement égale à 20mm. Ces plaques permettent d'obtenir un lingot ayant sensiblement les dimensions suivantes 200^{∗}200^{∗}150mm³.

Si le système de fixation est réalisé au moyen de vis et d'écrous, les plaques sont usinées afin de prévoir les orifices nécessaires au placement des vis et des écrous. Selon les dimensions des trous par rapport aux vis et aux écrous, le système de serrage 4 peut autoriser ou interdire un déplacement des plaques selon deux axes différents.

De manière avantageuse, les plaques adjacentes sont assemblées deux à deux au moyen de trois vis composites M8. La surface de contact des écrous est égale à 14^{∗}15mm². Un film en graphite expansé comprimé est utilisé en tant qu'élément déformable. Deux rondelles ayant chacune une épaisseur égale à 2mm sont utilisées. Le matériau utilisé présente une déformation sensiblement égale à 10% pour une contrainte de l'ordre de 4,2 MPa et une déformation sensiblement égale à 52% pour une contrainte de l'ordre de 17,5 MPa.

Dans une telle configuration, si les vis composites sont serrées initialement avec une contrainte égale à 26MPa, après solidification la contrainte est sensiblement égale à 44MPa. Cette valeur est nettement inférieure à la contrainte admise par ce type de matériau (environ 100MPa).

La contrainte appliquée sur un lingot en silicium est inférieure à 0,25 MPa ce qui est très inférieur aux contraintes d'origines thermomécaniques généralement engendrées dans les lingots par les gradients de températures présents au cours du refroidissement. La déformation élastique correspondante du lingot en fin de refroidissement est d'environ 2^{∗}10⁻⁶.

Les différents modes de réalisation évoqués ci-dessus peuvent être combinés entre eux dans un même creuset ainsi que les différentes variantes décrites.

Pour les plus gros creusets, une conception en deux parties est envisageable. Le creuset peut alors comporter une partie inférieure qui est dimensionnée pour former le lingot. La partie inférieure est associée à une partie supérieure permettant de recevoir la charge initiale (avant fusion). La partie inférieure est munie d'un système de serrage. La supérieure ou réhausse peut être dépourvue du système de serrage.

Il est particulièrement avantageux de prévoir un trou dans le creuset 1 qui est configuré pour permettre le passage d'une sonde autorisant le prélèvement de gaz. Le gaz prélevé est analysé pour déterminer la composition de l'atmosphère dans le creuset et notamment la teneur en CO.

Le creuset 1 est avantageusement destiné à être utilisé dans un dispositif de solidification dirigée pour obtenir des lingots de matériau cristallisé. Le dispositif comporte des moyens de génération d'un gradient thermique à l'intérieur du creuset 1. Les moyens de génération du gradient thermique comportent une source de chaleur qui peut être disposée, par exemple, au-dessus du creuset 1 ou sur les côtés du creuset 1. Les moyens de génération du gradient thermique comportent également un extracteur de chaleur qui est disposé sous le creuset 1.

En modulant la quantité de chaleur émise par la source de chaleur et absorbée par l'extracteur de chaleur, il est possible de moduler la température dans le creuset 1 et la forme du gradient thermique à l'intérieur du creuset 1.

Dans un mode de réalisation préférentiel, l'extracteur de chaleur est disposé face au fond 2 du creuset 1. L'extracteur de chaleur absorbe alors de la chaleur via le fond 2 du creuset. Ceci permet de maintenir des isothermes plus planes et plus parallèles au fond 2 du creuset 1. De manière préférentielle, l'extracteur de chaleur fait face à l'intégralité de la surface du fond 2 du creuset 1 afin d'avoir des isothermes très planes et parallèles au fond 2 du creuset sur tout le creuset.

Le matériau à solidifier déposé dans le creuset 1 est, par exemple du silicium, du germanium, de l'arséniure de gallium... Un germe peut être utilisé dans le fond 2 du creuset 1. Ce germe peut être un germe monocristallin ou multicristallin.

Une charge de silicium de qualité solaire est déposée dans le creuset 1. La charge est fondue. La solidification est initiée par exemple à partir du germe monocristallin afin d'imposer l'orientation cristalline recherchée. Un ou plusieurs thermocouples sont disposés sous le creuset 1 afin de déterminer la position de la température de fusion du silicium dans le creuset par rapport au fond 2 du creuset 1.

Classiquement, le gradient thermique à l'intérieur du creuset 1 est vertical, la température diminuant du haut du creuset 1 vers le fond 2. Ainsi, la solidification du matériau à l'intérieur du creuset 1 entraîne la formation de joints de grains perpendiculaires au fond 2 du creuset 1. Cette configuration est avantageuse pour une utilisation dans des dispositifs photovoltaïques.

La régulation thermique au sein du creuset 1, est réalisée par tout moyen connu de façon à maintenir, stable et vertical, le gradient thermique au sein du creuset 1.

Plusieurs cycles de cristallisation ont été réalisés au moyen d'un creuset en graphite muni du système de serrage 4 et d'une couche imperméable.

Le creuset est en graphite de nuance 2320 commercialisé par la société MERSEN. Toutes les surfaces sont recouvertes d'une couche imperméable en SiC. La couche anti-adhérente est réalisée à partir de poudre de nitrure de silicium.

Le système de serrage 4 est assuré par un jeu de vis et d'écrous associé à une ou plusieurs rondelles en graphite. Avantageusement, deux rondelles en graphite sont superposées. L'épaisseur de l'élément déformable 6 est égale à 4mm.

Une charge de silicium égale à 11kg est disposée dans un creuset de type G1 ayant une section carrée de 200mm de côté. Cette charge est fondue, cristallisée puis démoulée.

Le creuset précédent est utilisé et il est de nouveau recouvert de la couche anti-adhérente 5. Il est avantageux de changer les éléments déformables 6 après chaque cycle de fusion solidification.

Une deuxième charge de silicium égale à 11kg est disposée dans le creuset. Cette charge est fondue, cristallisée puis démoulée.

Une troisième charge de silicium puis une quatrième charge de silicium sont fondues et cristallisées dans le même creuset. A chaque fois la couche anti-adhérente est reformée selon le même protocole que précédemment.

Après le démoulage, les plaques formant le fond 2 et les parois latérales 3 sont inspectées. Comme les plaques ne sont pas détériorées, elles peuvent être réutilisées ce qui permet d'utiliser un même creuset 1 pour plusieurs cycles de fusion/cristallisation.

Le même résultat a aussi été obtenu en réutilisant les plaques sans redéposer un nouveau revêtement anti-adhérent avant la nouvelle cristallisation.

Pour l'assemblage d'un creuset, il est avantageux de fixer ensemble les parois latérales 3 pour former initialement un creuset par exemple sans fond. Ensuite, le fond 2 est fixé aux plaques latérales. Dans un mode de mise en oeuvre particulièrement intéressant, les plaques formant les parois latérales 3 sont assemblées ensemble verticalement ce qui permet de faciliter l'alignement des extrémités inférieures des plaques dans un même plan horizontal.

Dans les modes de réalisation décrits, la charge est en silicium et le creuset est en graphite de sorte que le creuset présente un coefficient de dilatation thermique qui est supérieur est à celui du silicium. L'homme du métier gardera à l'esprit que le matériau formant le creuset et le matériau formant la charge peuvent être différents. En effet, rien n'empêche d'utiliser une charge dont le matériau possède un coefficient de dilatation supérieur à celui du creuset. Le creuset décrit ci-dessus peut donc être utilisé avec une plus grande gamme de matériaux que les creusets selon l'art antérieur sans se préoccuper du coefficient de dilatation du matériau à cristalliser.

Cette configuration permet de former un creuset 1 comportant un fond 2 et des parois latérales 3 dont le fond et/ou au moins une des parois latérales est formé par un matériau ayant un coefficient de dilatation thermique moyen dans une gamme de température comprise entre la température ambiante et la température de fusion du matériau cristallin qui est supérieur au coefficient de dilatation thermique du matériau cristallin dans ladite gamme de température. De cette manière, il est possible de former un creuset avec des matériaux qui étaient considérés comme inadaptés à la réalisation d'un creuset.

## Revendications

1. Creuset (1) pour la fabrication d'un lingot en silicium par solidification comportant un fond (2) et des parois latérales (3) formées au moins partiellement par un matériau réfractaire,
**caractérisé en ce que** :
- le matériau réfractaire est du graphite présentant un coefficient de dilatation thermique moyen, dans une gamme de température comprise entre la température ambiante et la température de fusion du silicium, supérieur ou égale au coefficient de dilatation thermique dudit silicium dans ladite gamme de température,
- les parois latérales (3) du creuset (1) sont au moins en partie recouvertes d'une couche imperméable à l'air à base de carbure de silicium,
- et le creuset comporte un système de serrage (4) connectant deux parois latérales (3) adjacentes, le système de serrage (4) étant configuré pour autoriser l'écartement des deux parois latérales (3) adjacentes si une contrainte seuil est appliquée sur le système de serrage (4), le système de serrage (4) comportant un élément déformable comprimé, autorisant le déplacement des deux parois par déformation de l'élément déformable.

2. Creuset selon la revendication 1, **caractérisé en ce que** le système de serrage (4) est configuré de sorte que la contrainte appliquée par les parois latérales (3) sur le silicium cristallisé (9) est inférieure à 1 MPa.

3. Creuset selon l'une des revendications 1 et 2, **caractérisé en ce que** le système de serrage (4) comporte un élément déformable (6), configuré pour se comprimer si la contrainte seuil de traction est appliquée sur le système de serrage (4).

4. Creuset selon la revendication 3, **caractérisé en ce que** l'élément déformable est formé par un matériau compressible réfractaire et/ou il présente une forme autorisant sa compression lors de l'application de la contrainte seuil de traction, par exemple sous la forme d'un ressort.

5. Creuset selon l'une quelconque des revendications 1 à 4, **caractérisé en ce que** le matériau compressible réfractaire est choisi parmi les matériaux réfractaires métalliques, céramiques, en carbone tel qu'un graphite souple, et les composites carbone-carbone.

6. Creuset selon l'une des revendications 3 à 5, **caractérisé en ce que** le système de serrage (4) comporte une vis, un écrou et une rondelle (6) en graphite souple formant l'élément déformable, la rondelle étant configurée pour se comprimer lorsque la contrainte seuil de traction est appliquée entre la vis (7) et l'écrou (8).

7. Creuset selon l'une quelconque des revendications 1 à 6, **caractérisé en ce que** le matériau réfractaire étant du graphite, il est choisi parmi du graphite extrudé, du graphite vibrotassé et du graphite isostatique.

8. Creuset selon l'une quelconque des revendications 1 à 7, **caractérisé en ce que** les parois latérales (3) du creuset (1) sont au moins en partie, recouvertes d'une couche anti-adhérente.

9. Creuset selon la revendication 8, **caractérisé en ce que** la couche anti-adhérente est à base de nitrure de silicium et/ou d'oxyde de silicium.

10. Creuset selon l'une quelconque des revendications 1 à 9, **caractérisé en ce que** les parois latérales (3) du creuset (1) sont constituées par le matériau réfractaire.

11. Creuset selon l'une quelconque des revendications 1 à 10, **caractérisé en ce que** chaque paroi latérale (3) est connectée à la paroi latérale (3) adjacente au moyen d'un système de serrage (4).

12. Procédé de fabrication d'un creuset (1) selon l'une quelconque des revendications 1 à 11 **caractérisé en ce qu'**il comporte :
- Fournir au moins deux parois latérales (3) formées au moins partiellement par un matériau réfractaire en graphite ayant un coefficient de dilatation thermique moyen, dans une gamme de température comprise entre la température ambiante et la température de fusion du silicium, supérieur ou égale au coefficient de dilatation thermique dudit silicium dans ladite gamme de température,
- Assembler les parois latérales (3), les au moins deux parois latérales (3) adjacentes étant connectées au moyen du système de serrage (4), le système de serrage (4) étant configuré pour autoriser l'écartement des deux parois latérales (3) adjacentes si une contrainte seuil est appliquée sur les moyens de serrage (4),
- Assembler le fond (2) aux parois latérales (3).

13. Procédé de fabrication d'un lingot en silicium par solidification d'un matériau en phase liquide dans un creuset (1) **caractérisé en ce qu'**il comporte :
- prévoir un creuset (1) selon l'une quelconque des revendications 1 à 11, le creuset (1) étant au moins partiellement rempli par une charge de matériau à solidifier,
- générer un premier gradient thermique dans le creuset (1) de manière à faire fondre le matériau à solidifier,
- générer un second gradient thermique dans le creuset (1) de manière à solidifier le matériau à l'état fondu.

## Patentansprüche

1. Tiegel (1) zur Herstellung eines Barrens aus Silicium durch Erstarren, wobei er einen Boden (2) und Seitenwände (3) umfasst, welche zumindest teilweise aus einem hitzebeständigen Material gebildet sind,
**dadurch gekennzeichnet, dass**:
- es sich bei dem hitzebeständigen Material um Graphit handelt, der einen mittleren Wärmeausdehnungskoeffizienten aufweist, welcher im Temperaturbereich zwischen der Raumtemperatur und der Schmelztemperatur von Silicium mindestens so hoch wie der Wärmeausdehnungskoeffizient des Siliciums in diesem Temperaturbereich ist,
- die Seitenwände (3) des Tiegels (1) mindestens teilweise von einer luftundurchlässigen Schicht auf Basis von Siliciumcarbid bedeckt sind,
- und der Tiegel ein Klemmsystem (4) aufweist, das zwei aneinandergrenzende Seitenwände (3) miteinander verbindet, wobei das Klemmsystem (4) derart ausgelegt ist, dass es zulässt, dass die beiden aneinandergrenzenden Seitenwände (3) sich voneinander entfernen, wenn ein Schwellenwert der Belastung auf das Klemmsystem (4) einwirkt, wobei das Klemmsystem (4) ein komprimiertes verformbares Element aufweist, welches eine Bewegung der beiden Wände durch Verformung des verformbaren Elements zulässt.

2. Tiegel nach Anspruch 1, **dadurch gekennzeichnet, dass** das Klemmsystem (4) derart ausgelegt ist, dass die Belastung, welche über die Seitenwände (3) auf das kristallisierte Silicium (9) einwirkt, geringer als 1 MPa ist.

3. Tiegel nach einem der Ansprüche 1 und 2, **dadurch gekennzeichnet, dass** das Klemmsystem (4) ein verformbares Element (6) aufweist, das dafür ausgelegt ist, eine Kompression zu erfahren, wenn der Schwellenwert der Zugbelastung auf das Klemmsystem (4) einwirkt.

4. Tiegel nach Anspruch 3, **dadurch gekennzeichnet, dass** das verformbare Element aus einem hitzebeständigen komprimierbaren Material gebildet ist und/oder eine Gestalt aufweist, die es zulässt, dass es unter Einwirkung des Schwellenwerts der Belastung komprimiert wird, wobei es beispielsweise in Form einer Feder vorliegt.

5. Tiegel nach einem beliebigen der Ansprüche 1 bis 4, **dadurch gekennzeichnet, dass** das hitzebeständige komprimierbare Material aus den hitzebeständigen Materialien ausgewählt ist, die metallisch, keramisch, aus Kohlenstoff sind, wie etwa aus einem Weichgraphit, sowie aus den Kohlenstoff-Kohlenstoff-Verbundstoffen.

6. Tiegel nach einem der Ansprüche 3 bis 5, **dadurch gekennzeichnet, dass** das Klemmsystem (4) eine Schraube, eine Mutter sowie eine Ringscheibe (6) aus Weichgraphit aufweist, welche das verformbare Element bildet, wobei die Ringscheibe dafür ausgelegt ist, eine Kompression zu erfahren, wenn der Schwellenwert der Zugbelastung zwischen der Schraube (7) und der Mutter (8) einwirkt.

7. Tiegel nach einem beliebigen der Ansprüche 1 bis 6, **dadurch gekennzeichnet, dass** es sich bei dem hitzebeständigen Material um Graphit handelt, wobei dieser aus extrudiertem Graphit, vibrationsverdichtetem Graphit und isostatischem Graphit ausgewählt ist.

8. Tiegel nach einem beliebigen der Ansprüche 1 bis 7, **dadurch gekennzeichnet, dass** die Seitenwände (3) des Tiegels (1) mindestens teilweise von einer Antihaftschicht bedeckt sind.

9. Tiegel nach Anspruch 8, **dadurch gekennzeichnet, dass** die Antihaftschicht auf Basis von Siliciumnitrid und/oder Siliciumoxid ist.

10. Tiegel nach einem beliebigen der Ansprüche 1 bis 9, **dadurch gekennzeichnet, dass** die Seitenwände (3) des Tiegels (1) aus dem hitzebeständigen Material bestehen.

11. Tiegel nach einem beliebigen der Ansprüche 1 bis 10, **dadurch gekennzeichnet, dass** jede der Seitenwände (3) mittels eines Klemmsystems (4) mit der angrenzenden Seitenwand (3) verbunden ist.

12. Verfahren zur Herstellung eines Tiegels (1) nach einem beliebigen der Ansprüche 1 bis 11, **dadurch gekennzeichnet, dass** es Folgendes umfasst:
- Bereitstellen von mindestens zwei Seitenwänden (3), die mindestens teilweise aus einem hitzebeständigen Material aus Graphit gebildet sind, das einen mittleren Wärmeausdehnungskoeffizienten aufweist, welcher im Temperaturbereich zwischen der Raumtemperatur und der Schmelztemperatur von Silicium mindestens so hoch wie der Wärmeausdehnungskoeffizient des Siliciums in diesem Temperaturbereich ist,
- Zusammenfügen der Seitenwände (3), wobei die mindestens zwei aneinandergrenzenden Seitenwände (3) mittels des Klemmsystems (4) miteinander verbunden werden, wobei das Klemmsystem (4) derart ausgelegt ist, dass es zulässt, dass die beiden aneinandergrenzenden Seitenwände (3) sich voneinander entfernen, wenn ein Schwellenwert der Belastung auf die Klemmmittel (4) einwirkt,
- Anfügen des Bodens (2) an die Seitenwände (3).

13. Verfahren zur Herstellung eines Barrens aus Silicium durch Erstarren eines Materials in flüssiger Phase in einem Tiegel (1), **dadurch gekennzeichnet, dass** es Folgendes aufweist:
- Bereitstellen eines Tiegels (1) nach einem beliebigen der Ansprüche 1 bis 11, wobei der Tiegel (1) mindestens teilweise mit einer Charge aus Material gefüllt ist, das erstarren soll,
- Erzeugen eines ersten Temperaturgradienten in dem Tiegel (1), sodass das Material, welches erstarren soll, zum Schmelzen gebracht wird,
- Erzeugen eines zweiten Temperaturgradienten in dem Tiegel (1), sodass das Material, welches als Schmelze vorliegt, erstarrt.

## Claims

1. Crucible (1) for the fabrication of a silicon ingot by solidification comprising a bottom wall (2) and side walls (3) at least partially formed by a refractory material,
**characterised in that**:
- the refractory material is graphite presenting a mean coefficient of thermal expansion, in a temperature range comprised between room temperature and the melting temperature of silicon, that is higher than or equal to the coefficient of thermal expansion of said silicon in said temperature range,
- the side walls (3) of the crucible (1) are at least partially covered by a layer impermeable to air made from silicon carbide,
- and the crucible comprises a clamping system (4) connecting two adjacent side walls (3), the clamping system (4) being configured to allow the two adjacent side walls (3) to move away from one another if a threshold stress is applied on the clamping system (4), the clamping system (4) comprising a compressed deformable part (6) allowing displacement of the two walls by deformation of the deformable part.

2. Crucible according to claim 1, **characterised in that** the clamping system (4) is configured so that the stress applied by the side walls (3) on the crystallised silicon (9) is lower than 1 MPa.

3. Crucible according to one of claims 1 and 2, **characterised in that** the clamping system (4) comprises a deformable part (6) configured to be compressed when the threshold tensile stress is applied on the clamping system (4).

4. Crucible according to claim 3, **characterised in that** the deformable part (6) is formed by a refractory compressible material and/or it presents a shape allowing it to be compressed when the threshold tensile stress is applied, for example in the form of a spring.

5. Crucible according to any one of claims 1 to 4, **characterised in that** the refractory compressible material is chosen from metallic or ceramic refractory materials, refractory materials made from carbon such as a flexible graphite, and carbon-carbon composites.

6. Crucible according to one claims 3 to 5, **characterised in that** the clamping system (4) comprises a bolt, a nut and a washer (6) made from flexible graphite forming the deformable part, the washer being configured to be compressed when the threshold tensile stress is applied between the bolt (7) and nut (8).

7. Crucible according to any one of claims 1 to 6, **characterised in that** the refractory material being graphite, it is chosen from extruded graphite, vibro-compacted graphite or isostatic graphite.

8. Crucible according to any one of claims 1 to 7, **characterised in that** the side walls (3) of the crucible (1) are at least partially covered by an anti-adhesive layer.

9. Crucible according to claim 8, **characterised in that** the anti-adhesive layer is made from silicon nitride and/or silicon oxide base.

10. Crucible according to any one of claims 1 to 9, **characterised in that** the side walls (3) of the crucible (1) are made from the refractory material.

11. Crucible according to any one of claims 1 to 10, **characterised in that** each side wall (3) is connected to the adjacent side wall (3) by means of a clamping system (4).

12. Method for fabrication of a crucible (1) according to any one of claims 1 to 11 **characterised in that** it comprises:
- providing at least two side walls (3) at least partially formed by a refractory graphite material having a mean coefficient of thermal expansion, in a temperature range comprised between room temperature and the melting temperature of silicon, that is higher than or equal to the coefficient of thermal expansion of said silicon in said temperature range,
- assembling the side walls (3), the at least two adjacent side walls (3) being connected by means of the clamping system (4), the clamping system (4) being configured to allow the two adjacent side walls (3) to move away from one another when a threshold stress is applied on the clamping means (4),
- assembling the bottom wall (2) to the side walls (3).

13. Method for fabrication of a silicon ingot by solidification of a material in liquid phase in a crucible (1) **characterised in that** it comprises:
- providing a crucible (1) according to any one of claims 1 to 11, the crucible (1) being at least partially filled by a feedstock of material to be solidified,
- generating a first heat gradient in the crucible (1) so as to melt the material to be solidified,
- generating a second heat gradient in the crucible (1) so as to solidify the material in molten state.
